# EUROPEAN PATENT APPLICATION

(11) **EP 3 932 592 A1**
(43) Date of publication of application: **05.01.2022**
(21) Application number: 20762821.5
(22) Date of filing: 25.02.2020
(51) Int. Cl.: B22F 9/08, C22C 30/00, C22C 30/02, C22C 33/02, C22C 1/04, C22C 19/07, C22C 38/00, C23C 14/34

(54) **ALLOY SUITABLE FOR SPUTTERING TARGET MATERIAL**

(30) Priority: 26.02.2019 JP 2019032915
(71) Applicant: Sanyo Special Steel Co., Ltd., Himeji-shi, Hyogo 672-8677 (JP)
(72) Inventor: HASEGAWA Hiroyuki, Himeji-shi, Hyogo 672-8677 (JP)
(74) Representative: Müller-Boré & Partner Patentanwälte PartG mbB
(86) International application number: PCT/JP2020/007306
(87) International publication number: WO 2020/175424

(57) **Abstract**

A problem to be solved by the present invention is to provide an alloy that is suitable for a sputtering target material and easy to be produced by an atomization method, and, in order to solve the problem, the present invention provides an alloy containing: at least one selected from Co and Fe; B; C; and the balance being unavoidable impurities, wherein a concentration of C in the alloy is 50 ppm or more and 950 ppm or less, and wherein a composition of Co, Fe and B, excluding C and the unavoidable impurities, in the alloy is represented by the general formula: (Coₓ - Fe_{100-X)100-Y} - B_{Y}, wherein X is 0 or more and 100 or less, and Y is 10 or more and 65 or less.

## Description

### BACKGROUND OF THE INVENTION

### Field of the Invention

The present invention relates to an alloy suitable for a sputtering target material. Specifically, the present invention relates to an alloy used for producing a sputtering target material.

### Background Art

A magnetic random-access memory (MRAM) has a magnetic tunnel junction (MTJ) element. The MTJ element is characterized by a high tunnel magnetoresistance (TMR) signal and a low switching current density (Jc).

The magnetic tunnel junction (MTJ) element usually has a structure including two magnetic layers composed of a Co-Fe-B-based alloy, and an insulating layer composed of MgO that is sandwiched between the two magnetic layers. Such a magnetic layer is a thin film obtained by sputtering using a target material composed of a Co-Fe-B-based alloy. WO 2015/80009 (Patent Document 1) discloses a magnetic material sputtering target that consists of a sintered product containing B in an amount of 17 at% or more and 40 at% or less, and the balance being one or more elements selected from Co and Fe. Patent Document 1 also discloses that the magnetic material sputtering target contains one or more elements selected from Al, Cr, Cu, Hf, Mn, Ni, Ru, Si, Ta and W in an amount of 0.5 at% or more and 20 at% or less.

### Prior Art Document

### [Patent Document]

Patent Document 1: WO 2015/80009

### SUMMARY OF THE INVENTION

In Patent Document 1, powdered raw materials used for producing the sputtering target are produced by a gas atomization method. The powdered raw materials have the following composition: 17 to 40 at% of B and the balance being one or more elements selected from Co and Fe. Generally, in an atomization method, a metal or alloy powder is produced by melting metal or alloy raw materials in a crucible provided with a flow outlet (small orifice or nozzle), and spraying the molten materials flowing out through the flow outlet with a high-pressure gas or liquid, to disperse and solidify them. However, the composition disclosed in Patent Document 1 has a problem, since when the molten materials flow out, the flow outlet of the crucible is often clogged, which makes it difficult to perform a production process by using an atomization method.

An object of the present invention is to provide an alloy that is suitable for a sputtering target material and makes it easy to produce a powder by using an atomization method.

Traditionally, it is believed that carbon contained in a target material is one of the causes of cracks and the like generated during sputtering, and may impair characteristics of a thin film obtained by the sputtering. Thus, studies have been made in order to develop a technology for decreasing a carbon concentration in powdered raw materials for a target material. However, as a result of intensive studies, the present inventors found that if a predetermined amount of carbon is added to a Co-Fe-B-based alloy having a specific composition, this will contribute to improvement of clogging of a small orifice or nozzle, and thus accomplished the present invention.

That is, an alloy suitable for a sputtering target material according to the present invention contains: at least one selected from Co and Fe; B; C; and the balance being unavoidable impurities. The concentration of C in the alloy is 50 ppm or more and 950 ppm or less. The composition of Co, Fe and B, excluding C and the unavoidable impurities, in the alloy is represented by the general formula: (Co_{X}- Fe_{100-X})_{100-Y}-B_{Y}. In this formula, X is 0 or more and 100 or less, and Y is 10 or more and 65 or less.

It is preferable that the alloy further contains an additional metal element. When the additional metal element is represented by M, the composition of Co, Fe, B and M, excluding C and the unavoidable impurities, in the alloy is represented by the general formula: (Co_{X} - Fe_{100-X})_{100-Y-Z} - B_{Y} - M_{Z}. In this formula, X is 0 or more and 100 or less, Y is 10 or more and 65 or less, and Z is 0.5 or more and 30 or less. It is preferable that the metal element M consists of one or more selected from the group consisting of Ti, Zr, Hf, V, Nb, Ta, Cr, Mo, W, Mn, Re, Ru, Rh, Ir, Ni, Pd, Pt, Cu and Ag.

It is preferable that the alloy suitable for a sputtering target material is used to obtain a sputtering target material.

In producing an alloy powder by an atomization method in which the alloy suitable for a sputtering target material according to the present invention is used, a carbon concentration of 50 ppm or more and 950 ppm or less in the alloy makes it easy that the molten alloy flows out through a flow outlet of a crucible. Thus, in producing the alloy powder, occlusion of the flow outlet with the molten alloy can be prevented. The alloy powder is easy to produce. In addition, a sputtering target material that is a sintered product of the alloy powder has fewer defects such as cracks generated during sputtering, and does not impair characteristics of a thin film obtained by the sputtering.

### DETAILED DESCRIPTION OF THE INVENTION

The present invention will now be described in detail with reference to preferable embodiments. As used herein, the term "ppm" means "mass ppm", unless otherwise specified.

In an embodiment of the present invention, an alloy suitable for a sputtering target material is a Co-Fe-B-based alloy containing: at least one selected from Co and Fe; B; C; an additional metal element added optionally; and the balance being unavoidable impurities. The concentration of C (carbon concentration) in the alloy is 50 ppm or more and 950 ppm or less. The composition of Co, Fe and B, excluding C and the unavoidable impurities, in the alloy is represented by the general formula: (Co_{X} - Fe_{100-X})_{100-Y} - B_{Y}. In this formula, X is 0 or more and 100 or less, and Y is 10 or more and 65 or less.

An alloy powder suitable as a raw material powder of a target material can be obtained from the alloy suitable for a sputtering target material. The alloy powder suitable for a sputtering target material (hereinafter referred to as a "powder", "alloy powder" or "raw material powder" in some cases) is also encompassed in the technical scope of the present invention.

The alloy powder suitable for a sputtering target material can be produced by melting raw materials containing: at least one selected from Co and Fe; B; C; an additional metal element added optionally; and the balance being unavoidable impurities, to form molten materials, and rapidly cooling the molten materials by atomization. Specifically, the alloy powder can be produced by introducing raw materials, i.e., at least one selected from Co and Fe; B; C; and an additional metal element added as an optional component into a crucible so that the raw materials have a predetermined composition, melting the raw materials, and spraying the molten materials flowing out through a flow outlet (small orifice or nozzle) of the crucible with a high-pressure gas or liquid, to disperse and solidify them.

The greatest feature of the present invention is that the concentration of C (carbon concentration) in the molten materials flowing out of the crucible is adjusted to 50 ppm or more and 950 ppm or less. If the molten materials have a carbon concentration of 50 ppm or more and 950 ppm or less, the molten materials will rapidly flow out through the flow outlet of the crucible without occluding the flow outlet. If the carbon concentration is less than 50 ppm, such an occlusion inhibition effect may not be obtained. From this viewpoint, the carbon concentration in the molten materials is adjusted to 50 ppm or more, preferably 70 ppm or more, more preferably 100 ppm or more. On the other hand, if the carbon concentration is more than 950 ppm, bubbles may undesirably be generated in the materials being molten in the crucible. From this viewpoint, the carbon concentration in the molten materials is adjusted to 950 ppm or less, preferably 500 ppm or less, more preferably 450 ppm or less.

As long as the effect of the present invention can be obtained, the carbon in the molten materials may be derived from the unavoidable impurities contained in the raw materials such as Co, Fe and B, or may be derived from a purposefully-added carbon source such as a carbon powder. In addition, as long as the carbon concentration of 50 ppm or more and 950 ppm or less can be obtained, an adjustment method of the carbon concentration is not particularly limited. Examples of such an adjustment method include an adjustment method including: calculating a carbon amount based on both of a composition ratio of metal raw materials, and a carbon concentration of each of the metal raw materials, which is measured by a known method such as an infrared absorption method; and adding a carbon powder so that a predetermined carbon concentration can be obtained.

The thus-obtained alloy powder is an aggregate of many particles, and the powder is composed of the alloy suitable for a sputtering target material according to the present invention. The concentration of C in the alloy is 50 ppm or more, preferably 70 ppm or more, more preferably 100 ppm or more. The concentration of C in the alloy is 950 ppm or less, preferably 500 ppm or less, more preferably 450 ppm or less.

Additionally, for these alloy and alloy powder suitable for a sputtering target material, the composition of Co, Fe and B, excluding C and unavoidable impurities, in the raw materials to be introduced into the crucible is represented by the general formula: (Coₓ - Fe_{100-X})_{100-Y} - By, and is adjusted in such a manner that X in this formula is 0 or more and 100 or less, and that Y in this formula is 10 or more and 65 or less.

If Y is adjusted to 10 or more and 65 or less, that is, the number of B atoms is adjusted to 10 or more and 65 or less on the assumption that the total number of Co, Fe and B atoms is 100, the occlusion prevention effect obtained during atomization will be more remarkable. From this viewpoint, Y is 10 or more, preferably 12 or more, more preferably 15 or more. If Y is more than 65, the flow outlet may undesirably be occluded. From this viewpoint, Y is 65 or less, preferably 60 or less, more preferably 55 or less.

In the alloy suitable for a sputtering target material, Co and Fe are contained to impart magnetism to a thin film obtained from the sputtering target material. Accordingly, the alloy needs to contain at least one selected from Co and Fe. From the viewpoint of enhancing the magnetic property of the obtained thin film, the total atomic ratio of Co and Fe to all the elements in the alloy is preferably 35 at% or more, more preferably 40 at% or more, still more preferably 50 at% or more. The upper limit of the total atomic ratio of Co and Fe is not more than 90 at% in terms of the amount of the other elements.

As mentioned above, the alloy suitable for a sputtering target material may further contain an additional metal element as an optional component. The additional metal element can contribute to enhancement in the capability of the obtained thin film. When the additional metal element is represented by M, the composition of Co, Fe, B and M, excluding C and unavoidable impurities, in the alloy is represented by the general formula: (Co_{X} - Fe_{100-X})_{100-Y-Z} - B_{Y} - M_{Z}. In this formula, X is 0 or more and 100 or less, Y is 10 or more and 65 or less, and Z is 0.5 or more and 30 or less.

If Z is adjusted to 0.5 or more, that is, the number of M atoms is adjusted to 0.5 or more on the assumption that the total number of Co, Fe, B and M atoms is 100, the capability enhancement effect of the metal element M will be sufficiently obtained. From this viewpoint, Z is preferably 0.5 or more, more preferably 1 or more, particularly preferably 2 or more. On the other hand, if Z is more than 30, the effect will reach saturation (a plateau), and thus the cost-effectiveness may decrease. From this viewpoint, Z is preferably 30 or less, more preferably 25 or less, particularly preferably 20 or less.

The metal element M is suitably selected in accordance with the characteristics to be imparted to the obtained thin film. For example, the metal element M to be contained in order to enhance the magnetic property of the thin film preferably consists of one or more selected from the group consisting of Ti, Zr, Hf, V, Nb, Ta, Cr, Mo, W, Mn, Re, Ru, Rh, Ir, Ni, Pd, Pt, Cu and Ag. If two or more elements are contained as the metal element M, the above-mentioned Z is adjusted as the total amount of the two or more elements.

As mentioned above, the alloy powder suitable for a sputtering target material can be produced by an atomization method. For example, a crucible provided with a flow outlet in the form of a small orifice having a diameter of 1 to 15 mm can be used to produce the alloy powder. However, as long as a desired powder can be obtained, a crucible to be used is not particularly limited. The alloy powder can be produced without occluding such a small orifice having a diameter of 1 to 15 mm. An atomization method to be used is not particularly limited, and may be a gas atomization method, a liquid atomization method, or a centrifugal atomization method. In addition, when an atomization method is performed, a known atomization device and production conditions can be suitably selected and used.

A sintered product of the alloy powder can be formed by heating, solidifying and shaping the alloy powder obtained by an atomization method under high pressure. A sputtering target material can be obtained by processing the sintered product into a suitable shape by a mechanical means or the like.

In other words, the sputtering target material is composed of an alloy containing: at least one selected from Co and Fe; B; C; and the balance being unavoidable impurities. The concentration of C in the target material is 50 ppm or more and 950 ppm or less. The composition of Co, Fe and B, excluding C and the unavoidable impurities, in the target material is represented by the general formula: (Coₓ - Fe_{100-X})_{100-Y} - B_{Y}. In this formula, X is 0 or more and 100 or less, and Y is 10 or more and 65 or less.

It is preferable that the alloy constituting the sputtering target material further contains an additional metal element. When the additional metal element is represented by M, the composition of Co, Fe, B and M, excluding C and unavoidable impurities, is represented by the general formula: (Coₓ - Fe_{100-X})_{100-Y-Z} - B_{Y} - M_{Z}. In this formula, X is 0 or more and 100 or less, Y is 10 or more and 65 or less, and Z is 0.5 or more and 30 or less. The metal element M consists of one or more selected from the group consisting of Ti, Zr, Hf, V, Nb, Ta, Cr, Mo, W, Mn, Re, Ru, Rh, Ir, Ni, Pd, Pt, Cu and Ag.

As long as the effect of the present invention is not impaired, a method and conditions for solidifying and shaping the alloy powder suitable for a sputtering target material are not particularly limited. For example, a hot isostatic pressing method (HIP method), a hot pressing method, a spark plasma sintering method (SPS method), a hot extrusion method, or the like can be suitably selected. In addition, a method used to process a sintered product obtained by solidifying and shaping is not particularly limited. For example, a known mechanical processing means can be used.

It is preferable that the alloy powder obtained by an atomization method is subjected to sieve classification before being solidified and shaped. The sieve classification makes it possible to remove particles that have a particle diameter of 500 µm or more (coarse particles) and impair sintering. In this regard, as long as the effect of the present invention can be obtained, it is also possible that the alloy powder obtained by an atomization method is directly solidified and shaped to obtain a sputtering target material.

From the viewpoint of the strength of the obtained sputtering target material, the average particle diameter of the alloy powder is preferably 20 µm or more, more preferably 50 µm or more. The average particle diameter is preferably 300 µm or less, more preferably 200 µm or less. The average particle diameter of the alloy powder is adjusted in accordance with changes in production conditions during atomization and with sieve classification carried out thereafter.

The sputtering target material obtained by using the alloy suitable for a sputtering target material can be suitably used, for example, for sputtering to form a Co-Fe-B-based alloy thin film, which can be used for an MTJ element. Use of the target material makes it possible to prevent generation of defects such as cracks generated during sputtering. Use of the target material makes it possible to form a thin film having characteristics suitable for an MTJ element. The characteristics of the thin film are equal to the characteristics of a thin film obtained using a target material having a carbon concentration of less than of 50 ppm.

### EXAMPLES

The effect of the present invention will be now demonstrated with reference to Examples. However, the present invention should not be construed as being limited to the descriptions of the Examples.

### [Production of Alloy Powder]

In order to obtain the compositions shown in Tables 1 to 3, the raw materials were each weighed, introduced into a crucible composed of a refractory material, and molten by induction heating under reduced pressure in an Ar gas atmosphere. Then, the molten materials were allowed to flow out through the small orifice (having a diameter of 8 mm) provided in the lower portion of the crucible, and gas-atomized by using a high-pressure Ar gas to yield an alloy powder in each of Examples (Nos. 1 to 45) and an alloy powder in each of Comparative Examples (Nos. 46 to 49). The carbon concentration in each alloy powder was adjusted by addition a carbon powder in consideration of the amount of carbon contained in the raw materials, and measured by a non-dispersive infrared absorption method. In this regard, note that "100-X", which means the amount of Fe, is omitted from each of the compositions shown in Tables 1 to 3.

### [Atomizability]

To the composition in each of the Examples (Nos. 1 to 45) and the Comparative Examples (Nos. 46 to 49), gas-atomization was applied five times under the same conditions, and the presence or absence and degree of occlusion in the small orifice of the crucible was observed. The number of times when an alloy powder was obtained without occluding the small orifice during atomization is expressed as the number of successes in Tables 1 to 3. The number of successes is rated on the basis of the following criteria, and expressed as A or B in Tables 1 to 3.
A (excellent atomizability): the number of successes is three or more.
B (poor atomizability): the number of successes is two or less.

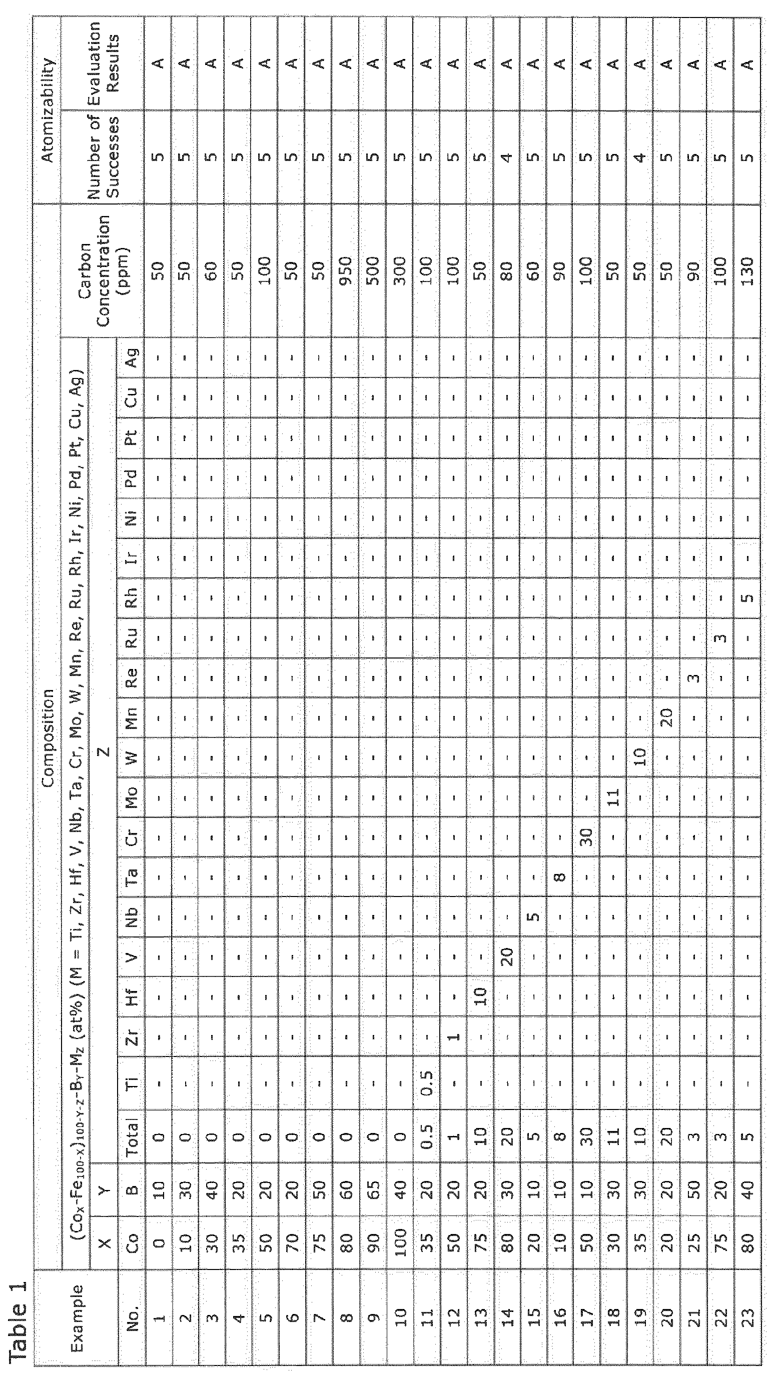

**Table 2**

| Example | Composition | | | | | | | | | | | | | | | | | | | | | | | Atomizability | |
|---|---|---|---|---|---|---|---|---|---|---|---|---|---|---|---|---|---|---|---|---|---|---|---|---|---|
| | (Co_{X}-Fe_{100-X})_{100-Y-Z}-B_{Y}-M_{Z} (at%) (M = Ti, Zr, Hf, V, Nb, Ta, Cr, Mo, W, Mn, Re, Ru, Rh, Ir, Ni, Pd, Pt, Cu, Ag) | | | | | | | | | | | | | | | | | | | | | | Carbon Concentration (ppm) | Number of Successes | Evaluation Results |
| | X | Y | Z | | | | | | | | | | | | | | | | | | | | | | |
| No. | Co | B | Total | Ti | Zr | Hf | V | Nb | Ta | Cr | Mo | W | Mn | Re | Ru | Rh | Ir | Ni | Pd | Pt | Cu | Ag | | | |
| 24 | 90 | 20 | 3 | - | - | - | - | - | - | - | - | - | - | - | - | - | 3 | - | - | - | - | - | 250 | 5 | A |
| 25 | 50 | 22 | 3 | - | - | - | - | - | - | - | - | - | - | - | - | - | - | - | 3 | - | - | - | 210 | 5 | A |
| 26 | 30 | 22 | 1 | - | - | - | - | - | - | - | - | - | - | - | - | - | - | - | - | 1 | - | - | 200 | 5 | A |
| 27 | 20 | 25 | 30 | 5 | 5 | - | - | - | - | - | - | - | - | - | - | - | - | - | - | - | 20 | - | 220 | 5 | A |
| 28 | 10 | 65 | 15 | 5 | - | 5 | - | - | - | - | - | - | - | - | - | - | - | - | - | - | - | 5 | 850 | 5 | A |
| 29 | 0 | 23 | 5 | 5 | - | - | - | - | - | - | - | - | - | - | - | - | - | - | - | - | - | - | 220 | 3 | A |
| 30 | 0 | 50 | 15 | 5 | - | - | - | 10 | - | - | - | - | - | - | - | - | - | - | - | - | - | - | 950 | 5 | A |
| 31 | 100 | 40 | 10 | 5 | - | - | - | - | - | - | 5 | - | - | - | - | - | - | - | - | - | - | - | 100 | 5 | A |
| 32 | 100 | 30 | 6 | 5 | - | - | - | - | - | - | - | - | - | 1 | - | - | - | - | - | - | - | - | 150 | 5 | A |
| 33 | 80 | 15 | 6 | 5 | - | - | - | - | - | - | - | - | - | - | 1 | - | - | - | - | - | - | - | 200 | 5 | A |
| 34 | 60 | 13 | 8 | 5 | - | - | - | - | - | - | - | - | - | - | - | 3 | - | - | - | - | - | - | 120 | 5 | A |
| 35 | 20 | 14 | 8 | 5 | - | - | - | - | - | - | - | - | - | - | - | - | 3 | - | - | - | - | - | 110 | 5 | A |
| 36 | 20 | 18 | 7 | 5 | - | - | - | - | - | - | - | - | - | - | - | - | - | - | 2 | - | - | - | 130 | 5 | A |
| 37 | 25 | 19 | 14 | - | 5 | - | 5 | - | - | - | 2 | - | - | 1 | - | - | - | - | - | 1 | - | - | 150 | 5 | A |
| 38 | 30 | 20 | 5 | - | - | - | - | - | - | - | - | - | - | - | - | - | - | - | - | - | 5 | - | 140 | 4 | A |
| 39 | 30 | 22 | 8 | - | - | - | - | - | - | - | - | - | - | - | - | - | - | - | - | - | - | 8 | 130 | 5 | A |
| 40 | 40 | 24 | 10 | - | - | - | - | - | 5 | - | - | - | 5 | - | - | - | - | - | - | - | - | - | 120 | 5 | A |
| 41 | 30 | 10 | 30 | 5 | - | - | - | - | - | 15 | - | - | - | 5 | 3 | 2 | - | - | - | - | - | - | 220 | 5 | A |
| 42 | 75 | 10 | 30 | - | - | - | 5 | - | 10 | 10 | - | - | - | - | - | - | - | - | - | - | - | 5 | 150 | 5 | A |
| 43 | 25 | 10 | 30 | - | 6 | - | - | - | - | - | - | 4 | 10 | - | - | - | - | - | - | - | 10 | - | 200 | 5 | A |
| 44 | 50 | 22 | 18 | 1 | 1 | 1 | 1 | 1 | 1 | 1 | 1 | 1 | 1 | 1 | 1 | 1 | 1 | - | 1 | 1 | 1 | 1 | 110 | 4 | A |
| 45 | 20 | 30 | 10 | - | - | - | - | - | - | - | - | - | - | - | - | - | - | 10 | - | - | - | - | 190 | 5 | A |

**Table 3**

| Comparative Example | Composition | | | | | | | | | | | | | | | | | | | | | | | Atomizability | |
|---|---|---|---|---|---|---|---|---|---|---|---|---|---|---|---|---|---|---|---|---|---|---|---|---|---|
| | (Co_{X}-Fe_{100-X})_{100-Y-Z}-B_{Y}-M_{Z} (at%) (M = Ti, Zr, Hf, V, Nb, Ta, Cr, Mo, W, Mn, Re, Ru, Rh, Ir, Ni, Pd, Pt, Cu, Ag) | | | | | | | | | | | | | | | | | | | | | | Carbon Concentration (ppm) | Number of Successes | Evaluation Results |
| | X | Y | Z | | | | | | | | | | | | | | | | | | | | | | |
| No. | Co | B | Total | Ti | Zr | Hf | V | Nb | Ta | Cr | Mo | W | Mn | Re Ru | | Rh | Ir | Ni | Pd | Pt | Cu | Ag | | | |
| 46 | 0 | 10 | 0 | - | - | - | - | - | - | - | - | - | - | - | - | - | - | - | - | - | - | - | 20 | 2 | B |
| 47 | 70 | 20 | 0 | - | - | - | - | - | - | - | - | - | - | - | - | - | - | - | - | - | - | - | 20 | 1 | B |
| 48 | 75 | 20 | 10 | - | - | 10 | - | - | - | - | - | - | - | - | - | - | - | - | - | - | - | - | 40 | 1 | B |
| 49 | 40 | 24 | 10 | - | - | - | - | - | 5 | - | - | - | 5 | - | - | - | - | - | - | - | - | - | 30 | 2 | B |

As shown in Tables 1 to 3, in each of the Examples (Nos. 1 to 45), the carbon concentration was adjusted to 50 to 950 ppm, and thus the number of successes in gas atomization was large, exhibiting excellent atomizability. On the other hand, in the Comparative Examples (Nos. 46 to 49), the carbon concentration was less than 50 ppm, and thus the number of successes in gas atomization was small, exhibiting poor atomizability. In the experimental examples carried out by using the carbon concentration of more than 950 ppm (the experimental examples are not shown in Tables 1 to 3), bubbles were generated in the crucible, thus failing to afford a desired powder.

### [Production of Sputtering Target Material]

The alloy powder in each of the Examples (Nos. 1 to 45) was used to produce a sputtering target material by the following procedure.

First, the alloy powder obtained by the gas atomization method was subject to sieve classification to remove coarse particles having a diameter of 500 µm or more. Next, the powder after the sieve classification was packed into a can (having an outer diameter of 220 mm, an inner diameter of 210 mm, and a length of 200 mm) formed of carbon steel, and subjected to vacuum degassing and then to an HIP method to yield a sintered product. The conditions for HIP were as follows.
Temperature: 1100°C
Pressure: 200 MPa
Retention time: 3 hours

The resulting sintered product was wire-cut, lathed, and surface-ground to be processed into a disc-shaped sputtering target material having a diameter of 180 mm and a thickness of 7 mm.

### [Sputtering Quality]

The sputtering target material produced by using the powder in each of the Examples (Nos. 1 to 45) was used for sputtering, and the target material after the sputtering was visually checked for any crack. No crack was observed in any of the target materials. By using any of the target materials, a thin film having a generally uniform thickness was formed on a substrate. These evaluation results have revealed that a target material having a carbon concentration of 50 ppm or more and 950 ppm or less enables good sputtering.

As described above, the alloys in the Examples are evaluated better than the alloys in the Comparative Examples. These evaluation results have clarified the superiority of the present invention.

As described above, the alloy suitable for a sputtering target material and the sputtering target material formed from the alloy can be used in various applications in which a thin film composed of a Co-Fe-B-based alloy is used.

## Claims

1. An alloy comprising: at least one selected from Co and Fe; B; C; and the balance being unavoidable impurities,
wherein:
a concentration of C in the alloy is 50 ppm or more and 950 ppm or less; and
a composition of Co, Fe and B, excluding C and the unavoidable impurities, in the alloy is represented by the general formula:
(Coₓ - Fe_{100-X})_{100-Y} - By
wherein X is 0 or more and 100 or less, and Y is 10 or more and 65 or less.

2. The alloy according to claim 1, wherein:
the alloy further comprises an additional metal element;
when the additional metal element is represented by M, a composition of Co, Fe, B and M, excluding C and the unavoidable impurities, in the alloy is represented by the general formula:
(Coₓ - Fe_{100-X})_{100-Y-Z} - By - M_{Z}
wherein X is 0 or more and 100 or less, Y is 10 or more and 65 or less, and Z is 0.5 or more and 30 or less; and
the metal element M consists of one or more selected from the group consisting of Ti, Zr, Hf, V, Nb, Ta, Cr, Mo, W, Mn, Re, Ru, Rh, Ir, Ni, Pd, Pt, Cu and Ag.

3. A sputtering target material obtained by using the alloy according to claim 1 or 2.
